# EUROPEAN PATENT APPLICATION

(11) **EP 3 972 156 A1**
(43) Date of publication of application: **23.03.2022**
(21) Application number: 21190283.8
(22) Date of filing: 09.08.2021
(51) Int. Cl.: H04B 10/50, H04B 10/61, H01S 5/50

(54) **INTEGRATED SEMICONDUCTOR OPTICAL AMPLIFIERS FOR SILICON PHOTONICS**

(30) Priority: 17.09.2020 US 202017024342
(71) Applicant: Intel Corporation, Santa Clara, CA 95054 (US)
(72) Inventor: Hong, Jin, Saratoga, 95070 (US); Kumar, Ranjeet, Milpitas, 95035 (US); Sakib, Meer Nazmus, Berkeley, 94710 (US); Rong, Haisheng, Pleasanton, 94566 (US); Nguyen, Kimchau, Los Gatos, 95030 (US); Huang, Mengyuan, Cupertino, 95014 (US); Eftekhar, Aliasghar, San Jose, 95134 (US); Malouin, Christian, San Jose, 95136 (US); Amiralizadeh Asl, Siamak, San Jose, 95134 (US); Fathololoumi, Saeed, Los Gatos, 95032 (US); Liao, Ling, Santa Clara, 95054 (US); Akulova, Yuliya, Sunnyvale, 94087 (US); Dosunmu, Olufemi, San Jose, 95125 (US); Liu, Ansheng, Cupertino, 95014 (US)
(74) Representative: Goddar, Heinz J.

(57) **Abstract**

Embodiments of the present disclosure are directed to a silicon photonics integrated apparatus that includes an input to receive an optical signal, a splitter optically coupled to the input to split the optical signal at a first path and a second path, a polarization beam splitter and rotator (PBSR) optically coupled with the first path or the second path, and a semiconductor optical amplifier (SOA) optically coupled with the first path or the second path and disposed between the splitter and the PBSR. Other embodiments may be described and/or claimed.

## Description

### Technical Field

Embodiments of the present disclosure generally relate to the field of photonic integrated circuits (PIC), in particular semiconductor optical amplifiers (SOA) integrated into silicon photonic devices.

### Background

Computing platforms are increasingly using photonic integrated circuits for coherent optical links to increase transmission capacity by modulating both amplitude and phase of an optical signal.

### Brief Description of the Drawings

Embodiments will be readily understood by the following detailed description in conjunction with the accompanying drawings. To facilitate this description, like reference numerals designate like structural elements. Embodiments are illustrated by way of example and not by way of limitation in the figures of the accompanying drawings.
FIG. 1 illustrates a coherent transmitter that includes hybrid integrated SOAs for pre-amplification before a modulator and post amplification after the modulator, in accordance with various embodiments.
FIG. 2 illustrates a coherent transmitter that includes a hybrid integrated SOA for pre-amplification before a modulator, in accordance with various embodiments.
FIG. 3 illustrates a coherent transmitter that includes a hybrid integrated SOA for post amplification after a modulator, in accordance with various embodiments.
FIG. 4 illustrates a coherent receiver that includes a hybrid integrated SOA for each of the X and Y polarization branches for pre-amplification before a detector, in accordance with various embodiments.
FIG. 5 illustrates an energy-efficient laser that incorporates a hybrid integrated SOA, in accordance with various embodiments.
FIG. 6 illustrates a transmitter that incorporates a hybrid integrated SOA with a micro ring modulator (MRM), in accordance with various embodiments.
FIG. 7 illustrates a receiver that incorporates a hybrid integrated SOA with a silicon (Si) photodetector (PD), in accordance with various embodiments.
FIG. 8 illustrates a silicon photonic integrated receiver that includes a dual polarization SOA and germanium (Ge) PD, in accordance with various embodiments.
FIG. 9 illustrates a silicon photonic integrated receiver with a polarization splitter-rotator (PSR), SOA, and Ge PD, in accordance with various embodiments.
FIG. 10 illustrates a silicon photonic integrated receiver with a PSR and combiner, SOA, and Ge PD, in accordance with various embodiments.
FIG. 11 illustrates a silicon photonic integrated receiver with a PSR and combiner, SOA, wavelength demultiplexer, and multiple Ge PDs, in accordance with various embodiments.
FIG. 12 illustrates a dual polarization transceiver with multiple SOAs, in accordance with various embodiments.
FIG. 13 illustrates filter locations within a dual polarization transceiver with multiple SOAs to eliminate excess amplified spontaneous emission (ASE), in accordance with various embodiments.
FIG. 14 schematically illustrates a computing device in accordance with one embodiment.

### Detailed Description

Embodiments described herein may be directed to a silicon photonics integrated apparatus that includes an input to receive an optical signal, a splitter optically coupled to the input to split the optical signal at a first path and a second path, a polarization beam splitter and rotator (PBSR) optically coupled with the first path or the second path, and a semiconductor optical amplifier (SOA) optically coupled with the first path or the second path and disposed between the splitter and the PBSR.

Silicon photonics high speed coherent in-phase quadrature (IQ) modulator and the associated receivers can support 600Gb/s transmission based on a 64GBaud and 64 quadrature amplitude modulation (QAM) high order modulation scheme. They can also support higher baud rate and higher QAM modulation combinations for higher rates of transmission beyond 600Gb/s, such as 800Gb/s or 1.2Tb/s, based on optimization of silicon photonics modulator physical layer designs.

One of the fundamental limitations to the performance of such kind of high-speed coherent IQ modulators is the optical loss incurred in the modulators. First, coherent IQ modulators require a number of elements, such as an optical splitter to split the signal into two different branches designated for two different polarizations, phase shifters, polarization rotator, polarization combiner, and many optical coupler taps at different locations in order to monitor the input or output optical power at different locations within the IQ modulator. These elements will cause significant power loss to the incoming optical power from the tunable laser. Second, and more important, the higher the order of the QAM modulation, the higher the effective optical loss. For example, for 400Gb/s applications based on 64Gbaud and a 16 QAM modulation scheme, the extra modulation induced optical signal loss is about 10dB. With the combination of the physical transmission induced loss and the modulation induced loss, and with the assumption that the increase of optical output power from the tunable laser is hard to achieve, for example, greater than 20dBm, it is difficult to have enough output optical power from the coherent IQ modulator operating at high order QAM modulation. The resulting output power may be low when high yield is needed. For example, in legacy configurations of silicon photonics based coherent 400G IQ modulators (64GBaud and 16 QAM), the output power is usually around - 8dBm to -12dBm. However, in many of the applications, the requirement may be -6dBm to +4dBm. The gap is anywhere from 2dB to 16dB depending on the applications for 400Gb/s case. For 600Gb/s, 800Gb/s or higher rate of operation with higher order QAM modulation, the modulation induced loss is much higher, and the output signal needs to be higher accordingly. So there is a challenge of a bottleneck of an ever larger gap in required optical power.

There are several legacy attempts to address this bottleneck. In one legacy implementation, and optical amplification element is added or co-packaged to the output of the tunable laser to boost the output power of the laser before it gets coupled into the modulator. In another legacy implementation, an optical amplification element may be co-packaged onto the output port of the silicon photonics modulator. In other legacy implementations, optical amplification elements can be co-packaged into the two receiver arms in order to increase the receiver sensitivity and increase the reach of the transmission from the transceiver to the receiver. In all of these legacy implementations, the coupling from outside elements into or from the silicon photonics modulator and receiver is challenging due to the added coupling loss, the need for complex coupling lenses, the increase in the package size, the need for optical isolators, and a significant amount of complex optical alignment work and associated cost. With these legacy implementations, the resulting packages may be too big, too costly, and unfit for pluggable module applications.

Other legacy implementations use silicon photonics based coherent IQ modulators and receivers without integrated SOAs. In these legacy implementations, power is not sufficient for 400Gb/s or 800Gb/s data center interconnect applications, nor for the metro applications where distances may be beyond 80km. These power challenges increase when higher order QAM modulation is used for a higher rate of transmission.

Embodiments described herein may be directed to hybrid integration technology of Indium Phosphide (InP) or other materials onto a silicon photonics platform. This technology increases the quality and reliability, compared to legacy implementations described above, and may be produced with a lower cost and higher volume. In addition, these embodiments may support complex integration of many different functions implemented on a photonics platform. Embodiments may include integrating hybrid InP-based SOAs into various arms of a silicon photonics based modulator and/or receiver.

Embodiments may be directed to a new transmitter architecture design where a silicon photonics modulator and receiver will be integrated with InP-based SOAs. In embodiments, they will be integrated using wafer bonding technology. Embodiments of these hybrid SOA integrated modulators and receiver combine the best of two material systems: InP for amplification and silicon photonics material for the modulator and receiver. Embodiments may enable high speed modulation to support high capacity coherent applications at 400Gb/s, 800Gb/s to 1 Tb/s per wavelength and beyond.

Additionally, legacy photonic communications systems require more optical power, particularly as speeds approach 1 Tbps/fiber. In embodiments described herein, various implementations of incorporating III-V/Si hybrid SOA in silicon photonics platforms may enable energy efficient, reduced complexity, and lower cost photonics systems. In particular, embodiments are disclosed that use optimized implementations of III-V/Si hybrid SOA at key locations within a photonics system to support higher data rates.

Silicon photonic optical transceivers offer an energy efficient high bandwidth density solution needed to overcome the I/O constraints in scaling high performance computing. Hybrid silicon optical amplifiers can be integrated in either the transmitter or receiver to amplify the optical signal and compensate for losses in the optical link as an alternative to a higher power laser source. Placing an SOA within a transmitter may limit the benefit of an SOA if the amplified back reflection to an integrated laser leads to elevated noise that will degrade the optical signal.

Embodiments may also be directed to an optical isolator placed after the laser or after the transmitter where one or more SOAs can be integrated in a silicon photonic receiver with germanium (Ge) photodetectors for optical amplification independent of negative effects to the laser. These embodiments may offer a low cost, scalable solution for input/output (I/O) in high performance computing. The integrated hybrid silicon SOA in the receiver amplifies the optical signal without constraints on the amplified back reflection destabilizing the laser that is integrated on the transmitter.

Silicon photonic optical transceivers also offer a low-cost, high-volume solution needed to implement coherent optical links with 400Gb/s, 800Gb/s, and higher data transmission rates with a pluggable form factor. Coherent optical links increase transmission capacity by modulating both the amplitude and phase of the optical signal. Higher-order modulation formats such as 16 QAM and 64 QAM encode 4- and 6-bits per symbol compared to 1-bit per symbol for on-off keying, for example. This may be combined with polarization division multiplexing (PDM) to double the data in the fiber by transmitting the coherent signal in two orthogonal polarizations.

A coherent dual-polarization transmitter may include a laser with IQ modulators, one for each polarization, and polarization rotator and combiner. The coherent optical receiver consists of a polarization beam splitter and rotator to separate the polarizations, then uses a local oscillator (a reference optical signal) mixed with the incoming SATA signal in a 90-degree optical hybrid with balanced photodetectors to convert the phase and amplitude modulated signal optical signal into the electrical domain. In a coherent transceiver, light from the same laser source can be split and used for both transmission and for the receiver local oscillator.

In legacy implementations, due to the losses of the components in the link, particularly from the IQ modulators themselves and the effective loss due to the modulation format, it is challenging to meet the link budget without amplification. In legacy implementations there may be a gap in power of 6-16dB depending on the application and the modulation format. In embodiments, including hybrid III-V Si semiconductor optical amplifiers (SOAs) and integrating them within the silicon photonic transceiver may provide a low-cost and compact solution to boost the signal in order to close the link.

In the following description, various aspects of the illustrative implementations will be described using terms commonly employed by those skilled in the art to convey the substance of their work to others skilled in the art. However, it will be apparent to those skilled in the art that embodiments of the present disclosure may be practiced with only some of the described aspects. For purposes of explanation, specific numbers, materials, and configurations are set forth in order to provide a thorough understanding of the illustrative implementations. It will be apparent to one skilled in the art that embodiments of the present disclosure may be practiced without the specific details. In other instances, well-known features are omitted or simplified in order not to obscure the illustrative implementations.

In the following detailed description, reference is made to the accompanying drawings that form a part hereof, wherein like numerals designate like parts throughout, and in which is shown by way of illustration embodiments in which the subject matter of the present disclosure may be practiced. It is to be understood that other embodiments may be utilized and structural or logical changes may be made without departing from the scope of the present disclosure. Therefore, the following detailed description is not to be taken in a limiting sense, and the scope of embodiments is defined by the appended claims and their equivalents.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C).

The description may use perspective-based descriptions such as top/bottom, in/out, over/under, and the like. Such descriptions are merely used to facilitate the discussion and are not intended to restrict the application of embodiments described herein to any particular orientation.

The description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

The term "coupled with," along with its derivatives, may be used herein. "Coupled" may mean one or more of the following. "Coupled" may mean that two or more elements are in direct physical or electrical contact. However, "coupled" may also mean that two or more elements indirectly contact each other, but yet still cooperate or interact with each other, and may mean that one or more other elements are coupled or connected between the elements that are said to be coupled with each other. The term "directly coupled" may mean that two or more elements are in direct contact.

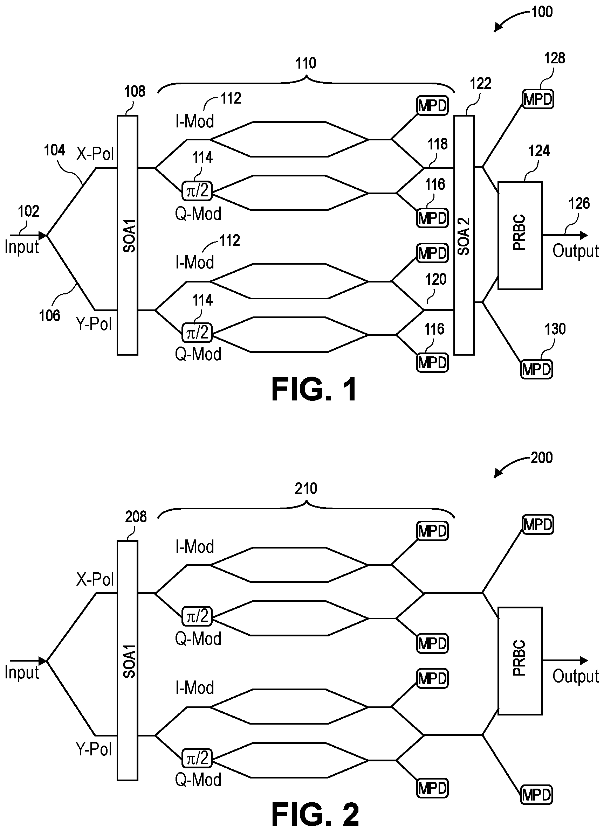

FIGs. 1-4 illustrate coherent transmitters and receivers that include hybrid integrated SOAs for amplification. These embodiments may include elements and structure of a Mach-Zehnder (MZ) modulator that is used for controlling the characteristics of an optical wave. For example, with an MZ modulator, an input waveguide is split up into two waveguide interferometer arms. If a voltage is applied across one of the arms, a phase shift is induced for the wave passing through that arm. When the two arms are recombined, the phase difference between the two waves is converted to an amplitude modulation.

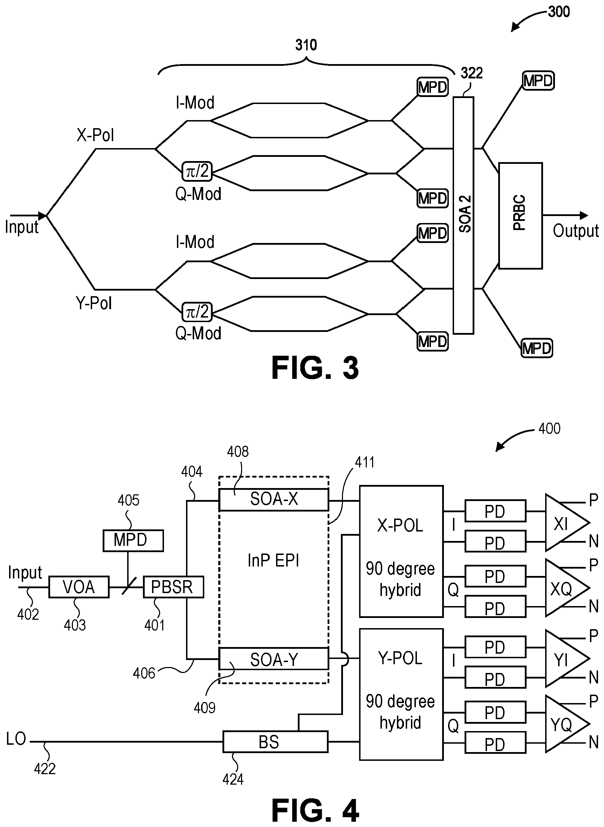

In embodiments, configurations of the silicon photonic hybrid SOA integrated modulator and receiver are in the shape of a MZ modulator and coherent receiver, wherein the SOA structure is defined in various locations in the MZ arms as shown in FIGs. 1-3 and in the receiver arms as shown in FIG. 4.

In embodiments, the SOAs may be defined by the silicon waveguides on the device wafer, which are in alignment with the underneath input and output waveguides of the MZ arms and receiver arms. For the booster amplifier, the laser light coming into the SOA input port is gradually coupled vertically upwards to the SOA epitaxial (EPI) materials and waveguide structure as defined by the implantation to the InP EPI materials. The output light from SOA is then gradually coupled downwards to the MZ's input waveguide. For the post modulation amplifier, the modulator output light coming into the SOA input port is gradually coupled vertically upwards to the SOA EPI materials and waveguide structure as defined by the implantation to the InP EPI materials. The output light from SOA is then gradually coupled downwards to the MZ's output waveguide.

FIG. 1 illustrates a coherent transmitter that includes hybrid integrated SOAs for pre-amplification before a modulator and post amplification after the modulator, in accordance with various embodiments. Transmitter 100 shows an input 102, which may be a waveguide input, that is split into an X polarization 104 and a Y polarization 106. The light is subsequently amplified using an InP SOA 108. In embodiments, there may be individual SOAs for each polarization 104, 106. The light may subsequently go through other splitting and coupling through an MZ structure 110 that may include in-phase modulators 112, quadrature modulator 114, and monitor photodiodes (MPD) 116.

The outputs 118, 120 of the MZ structure 100 then go through another InP SOA 122 for signal amplification prior to being combined by a Polarization Rotator Beam Combiner (PRBC) 124 and then outputted through output 126. In embodiments, there may be an individual SOA for each output 118, 120. In embodiments, the SOA 122 may also couple with MPDs 128, 130. In embodiments, transmitter 100 may be referred to as a coherent transmitter with a hybrid integrated SOA for each branch after the power splitter, where SOA 108 is used for pre-amplification before the MZ structure 110, and the SOA 122 is used for post amplification after the modulator.

FIG. 2 illustrates a coherent transmitter that includes a hybrid integrated SOA for pre-amplification before a modulator, in accordance with various embodiments. Transmitter 200 may be similar to transmitter 100 of FIG. 1; however, with transmitter 200 there is only a single SOA 208, which may be an InP SOA, prior to the MZ structure 210. In embodiments, transmitter 200 may be referred to as a coherent transmitter with hybrid integrated SOA for each branch after the power splitter, where SOA 208 is used for pre-amplification before the MZ structure 210.

FIG. 3 illustrates a coherent transmitter that includes a hybrid integrated SOA for post amplification after a modulator, in accordance with various embodiments. Transmitter 300 may be similar to transmitter 100 of FIG. 1; however, with transmitter 300 there is only a single SOA 322, which may be an InP SOA, after the MZ structure 310. In embodiments, transmitter 300 may be referred to as a coherent transmitter with hybrid integrated SOA for each branch after the power splitter, where SOA 322 is used for post amplification after the MZ structure 310.

FIG. 4 illustrates a coherent receiver that includes a hybrid integrated SOA for each of the X and Y polarization branches for pre-amplification before a detector, in accordance with various embodiments. Coherent receiver 400 includes an input 402 to receive light that is then passed through a variable optical attenuator (VOA) 403 and in contact with a monitoring photodetector (MPD) 405, and a PBSR 401. Subsequent to the PBSR 401, multiple hybrid SOAs, for example, an X polarization SOA 408, and a Y polarization SOA 409 that may be placed, respectively, in two different arms 404, 406 in order to amplify the received signals in both x polarization and y polarization. There may also be a local oscillator (LO) 422, which comes from a narrow lined with tunable laser source (not shown). The output of the LO 422 goes to a beam splitter 424, which combines with the output of SOA 408 and output of SOA 409 to feed the rest of the circuit of the coherent receiver 400.

Note, in embodiments, the X and Y polarization are referring to the input signal only. In embodiments, after the PBSR, the original X and Y polarization signals may have been converted into one orientation of physical optical polarization in the silicon photonics waveguides, normally called transverse electric (TE) mode; therefore, there are actually operated in the same polarization before they reach the SOAs 408, 409, and then subsequently amplified by SOAs 408, 409 in the same way. In embodiments, the SOAs 408, 409 may be in an InP EPI gain medium 411.

In embodiments with respect to FIGs. 1-3, SOAs may be placed in other locations, both outside and inside the MZ structure 110, 210, 310. Similarly, in embodiments with respect to FIG. 4, SOAs 408, 409 may be placed in various locations for amplification within the coherent receiver 400.

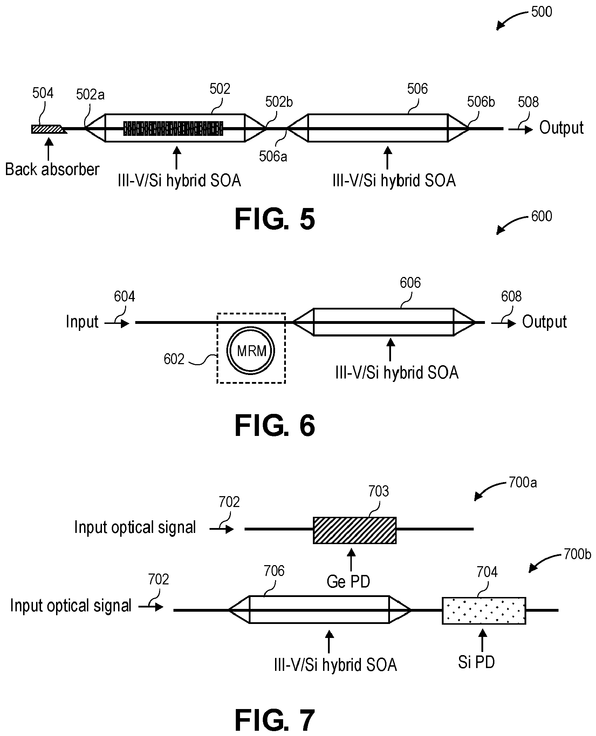

FIGs. 5-7 disclose techniques and embodiments of incorporating III-V/Si hybrid SOAs to enable energy-efficient and low cost implementations of various photonic elements including lasers (FIG. 5), micro ring modulators (FIG. 6), and photodiodes (FIG. 7).

FIG. 5 illustrates an energy-efficient laser that incorporates a hybrid integrated SOA, in accordance with various embodiments. Laser device 500 includes a laser 502 with a first end 502a that is optically coupled with a back absorber 504. The laser 502 has a second end 502b that is an output end optically coupled with a first end 506a of an SOA 506 to amplify a signal generated by the laser 502. The amplified signal is then sent through the output end 506b of the SOA 506 to the device output 508. In legacy implementations, the SOA 506 would be omitted.

Although laser output power is an important metric for any laser, efficiency of the laser is also an important metric for energy-efficient systems. Using a laser alone, such as laser 502, may be a challenge to meet both laser efficiency and output power requirements at the same time during operation. In embodiments, the laser 502 may be a III-V/Si hybrid laser, and the SOA 506 may be a III-V/Si hybrid SOA used to amplify the output of the laser 502.

SOA 506 may be used to provide the gain needed for a given target laser output specification. The SOA 506 may also provide an independent way to control the output optical power, which would otherwise be difficult in legacy implementations for a laser 502 to provide on its own. For example, this independent control may provide the opportunity to split the laser 502 into multiple parallel channels to increase data rates. In addition, these embodiments may also allow for greater flexibility in laser 502 design for a higher back reflection tolerance and operational stability.

For example, if ∼12 dBm power from a laser at 65C is desired, a legacy, energy inefficient solution is to bias the laser at 140 mA to reach the desired power. However, using embodiments described herein, it would be more energy efficient to use a combination of laser 502 and an SOA 506. In the example, the laser 502 may be biased at 55 mA, which may be the most efficient operating condition for the laser 502. Driving the laser higher than 55 mA results in higher output power, but the efficiency of the laser may substantially drop. In this example, the total electrical consumption from the laser 502 and the SOA 506 combination is 141 mW, with the laser 502 consuming 85 mW, giving ∼8 dBm power, and the SOA consuming 56 mW, giving 4 dB gain-compared to just the laser 502, which consumes 340 mW. Hence, with this example this change may result in a 240% more efficient system. Note: embodiments described herein directed to integrating an SOA may be valid for any photonic apparatus or system.

FIG. 6 illustrates a transmitter that incorporates a hybrid integrated SOA with an MRM, in accordance with various embodiments. Communication link 600 includes an MRM 602 that optically interacts with laser light from an input 604, and outputs light to an SOA 606. After leaving the SOA 606, the light travels to the output 608. Legacy implementations may use an MZ modulator, but increased requirements for data rates and power efficiency make MRMs 602 a better choice. For example, MRMs 602 are a few orders of magnitude smaller than MZ modulators, thus using MRMs 602 help deliver more channels per MRM in a given footprint (not shown). In addition, MRMs 602 are more power efficient, especially with respect to drive electronics. However, MRMs 602 are subject to self-heating, which is primarily caused by the amount of light circulating inside the MRM 602.

In embodiments, this amount of light received by an MRM 602 may be reduced without risking a closure of the communication link. By placing an SOA 606 after the MRM 602 to amplify the light, MRM self-heating problems may be removed and enable the communication link to be closed. In embodiments, signal quality remains within measurement error ranges when using an SOA 606 after the MRM 602 in the communication link 600.

FIG. 7 illustrates a receiver that incorporates a hybrid integrated SOA with a Si PD, in accordance with various embodiments. Legacy PD 700a shows an input optical signal 702 going into a Ge PD 703. Although the use of Ge PD 703 may provide a higher response activity, using Ge PD 703 involves a costly and complicated integration process, particularly when compared to implementing Si PDs as described below.

Photodetector 700b shows an embodiment where an input optical signal 702 goes into an SOA 706, with an output of the SOA 706 optically coupled to a Si PD 704. In embodiments, to attain error free detection, it is important to have sufficient signal strength. Embodiments may include replacing the Ge PD with III-V/Si SOA in addition to a Si PD 704. Si PDs can be fabricated through a much simpler process than a Ge PD, resulting in low cost of implementation. Although some Si PDs may have lower responsivity compared to a Ge PD, positioning the SOA 706 in front of the Si PD 704 will amplify the signal before it is detected by the Si PD 704.

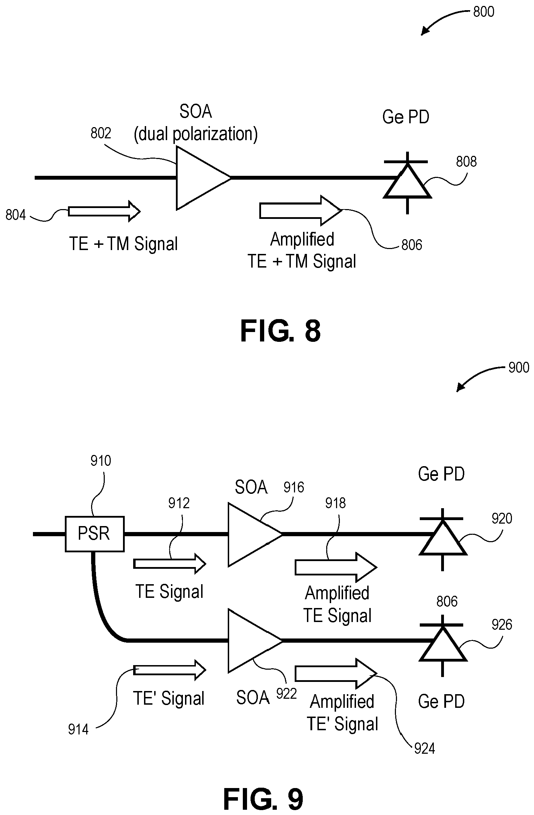

FIGs. 8-11 include a description of embodiments of directed architectures that integrate SOAs and Ge PDs. In embodiments, the polarization of the signal input to the receivers is randomized.

FIG. 8 illustrates a silicon photonic integrated receiver that includes a dual polarization SOA and Ge PD, in accordance with various embodiments. Integrated receiver 800 incorporates a dual polarization SOA 802 that amplifies an optical signal 804 that includes both TE and TM modes. Subsequently, the amplified optical signal 806 is received by Ge PD 808 for optical electrical conversion. In embodiments, the SOA 802 is a hybrid SOA, and may be a III-V/Si SOA.

FIG. 9 illustrates a silicon photonic integrated receiver with a polarization splitter-rotator (PSR), SOA, and Ge PD, in accordance with various embodiments. Integrated receiver with PSR 900 includes a PSR 910 to split an optical signal received by the PSR 910 into a TE signal 912 and a TE' signal 914. In embodiments, to create the TE' signal 914, the PSR 910 may split the optical signal into a TM component (not shown), and then rotate the polarization of the TM component to create a TE' signal 914.

In embodiments, the TE signal 912 is then amplified by a first SOA 916 to produce an amplified TE signal 918 to be sent to a first Ge PD 920. The TE' signal 914 is sent to a second SOA 922 to produce an amplified TE' signal 924 to be sent to a second Ge PD 926. In embodiments, there may be multiple SOAs 916, 922 that receive multiple types of signals from the PSR 910 that are routed to one or more Ge PD 920, 926. In embodiments, these multiple types of signals may include different polarizations. In embodiments, the SOA is not required to be dual polarization or polarization insensitive. In other embodiments, the SOA may be optimized for TE only gain.

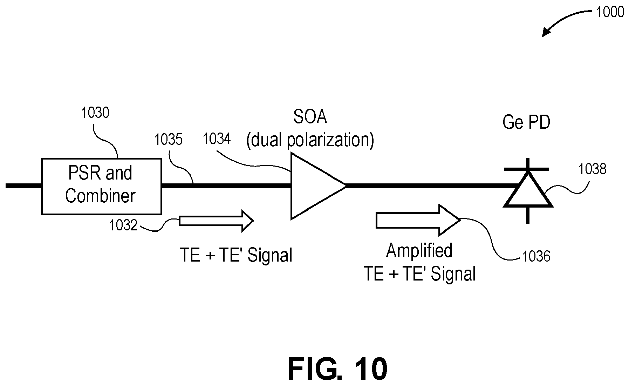

FIG. 10 illustrates a silicon photonic integrated receiver with a PSR and combiner, SOA, and Ge PD, in accordance with various embodiments. Integrated receiver 1000 includes a combination PSR and combiner 1030 component that receives an optical signal and produces a TE + TE' signal 1032 that is received by an SOA 1034 to produce an amplified TE + TE' signal 1036. The amplified TE + TE' signal 1036 is then sent to a Ge PD 1038. In these embodiments, the SOA 1034 is not required to be dual polarization or polarization insensitive; therefore, the SOA 1034 may be optimized for TE only amplification. The PSR and combiner 1030 splits the TE and TM (not shown) components of the input signal, rotates the polarization of the TM to a TE' signal, and then combines the TE and TE' together into one waveguide 1035 for amplification before conversion to an electrical signal at the Ge PD 1038.

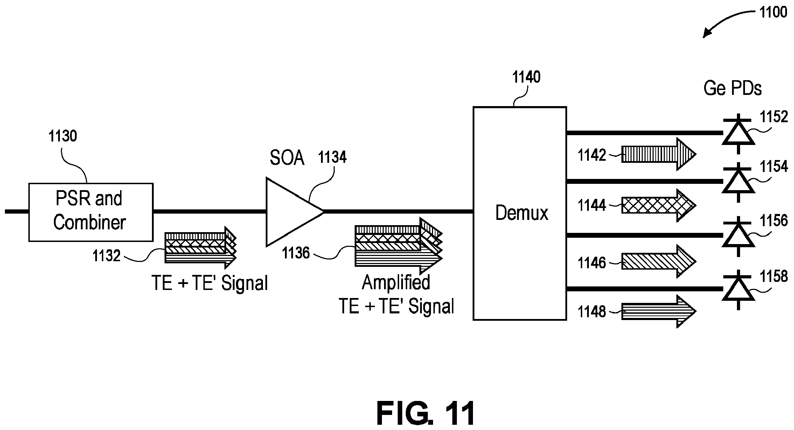

FIG. 11 illustrates a silicon photonic integrated receiver with a PSR and combiner, SOA, wavelength demultiplexer, and multiple Ge PDs, in accordance with various embodiments. Integrated wavelength division multiplexed receiver 1100 may include a PSR and combiner 1130, which may be similar to PSR and combiner 1030 of FIG. 10. The PSR and combiner 1130 may receive one or more optical signals and produce signals on multiple wavelengths of a TE and TE' signals 1132. The SOA 1034 is used to amplify multiple wavelengths of the TE and TE' signals 1132 and produce the amplified multiple wavelengths 1036. These multiple wavelengths 1036 are then routed to a demultiplexer 1040 to separate the individual wavelengths 1142, 1144, 1146, 1148, which are then routed, respectively, to Ge PDs 1152, 1154, 1156, 1158.

For the embodiments/architectures described above, the SOA may be operated below saturation to limit signal distortion. In embodiments, receivers 800, 900, 1000, 1100 may be expanded to include multiple channels and/or signals on multiple wavelengths in each channel. In embodiments, with signals on multiple wavelengths in each channel, an SOA 1134 may be used to amplify multiple wavelengths, with a demultiplexer 1140 separating out each individual wavelengths before proceeding to a Ge PD 1152, 1154, 1156, 1158.

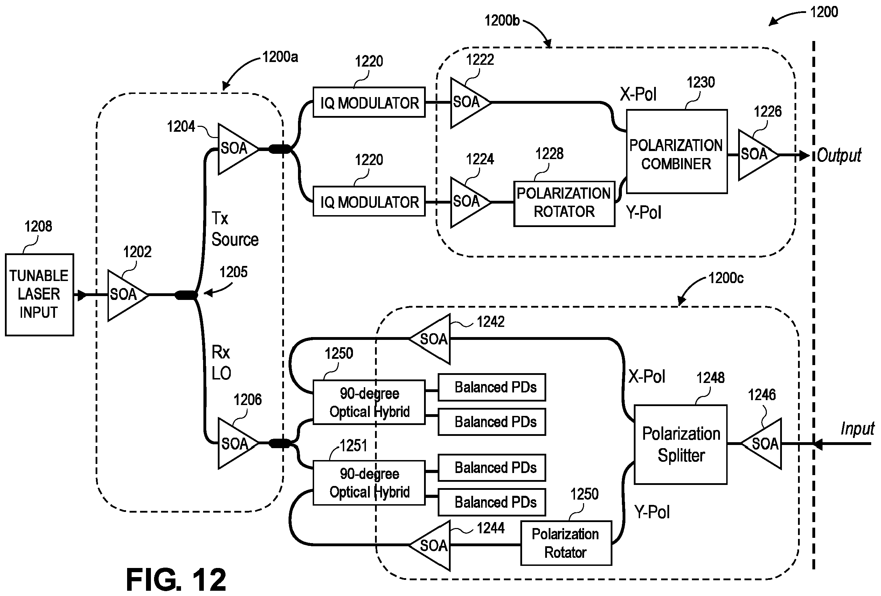

FIG. 12 illustrates a dual polarization transceiver with multiple SOAs, in accordance with various embodiments. Transceiver schematic 1200 shows a dual-polarization coherent transceiver that includes multiple options for SOA integration in both the transmitter and receiver portions of the schematic. In embodiments, the placement of an SOA in the coherent transceiver will dictate the requirements for the SOA. In a given placement, the SOA may or may not need to amplify data or have high output saturation power. Transceiver schematic 1200 is divided into three regions for SOA placement. Region 1200a includes SOA placement after an input to the transceiver 1200 and either before or after the splitter between the transmitter (region 1200b) and the receiver (region 1200c). Region 1200b includes SOA placement in the transmitter either after the IQ modulators or after the polarization rotator and combiner. Region 1200c includes SOA placement in the receiver before or after the polarization splitter and rotator. Embodiments of regions 1200a, 1200b, 1200c are described further below. These embodiments may be combined throughout the transceiver 1200 to form various embodiments.

Region 1200a includes embodiments of SOA placed for optical signal power boosting at an input to the transceiver, and either before or after the split between the transmitter (region 1200b) or the receiver (region 1200c). The SOAs 1202, 1204, 1206, which may be placed in locations as shown, may be used to boost optical signal received from a tunable laser input 1208. In embodiments, the SOAs 1202, 1204, 1206 may require high saturation power in these configurations. In embodiments, for SOA 1202, there may be only the coupling loss in the case of an off-chip tunable laser providing tunable laser input 1208. In embodiments, there may be splitter loss in the case where the SOAs 1204, 1206 are located after the splitter 1205.

For example, if the coupling loss is 3dB, and the splitter 1205 is 3dB, and gain required from the SOA is on the order of 9dB to close the link, the output power from the SOA will be 20dBm or 100mW in the case where the SOAs are after the splitter 1205. If SOAs 1204, 1206 are placed between the splitter 1205 for the two polarizations and the IQ modulators 1220, the output power from the SOAs 1204, 1206 will be 17dBm or 50mW. Both total power consumption of the SOA(s) and SOA reliability at high optical powers need to be considered for each SOA location option. Including more SOAs will inherently consume more electrical power, however operating at lower optical output power may be desirable from a component reliability standpoint, whether or not one option or the other is selected will depend on the overall system requirements. In the described option where SOAs 1204, 1206 are placed between splitter 1205 for the two polarizations and the IQ modulators 1220, the two SOAs 1204, 1206 will generally consume more power. However, in some cases this design may not be optimal because operating at a lower optical power can improve reliability as the failure rates improve with lower drive current and lower optical power. Whether or not the improved reliability is needed is based on the system requirements for each application.

The hybrid III-V/Si SOA is uniquely suited to achieve this high saturation power. Because the saturation power of an SOA is inversely proportional to the confinement factor, the overlap of the optical mode and the quantum well gain material, reducing the confinement factor increases saturation power. In the hybrid Si SOA, the III-V active region is bonded on top of a silicon waveguide and the confinement factor can be tuned by changing the width of the silicon waveguide. Widening the silicon waveguide pulls the mode down into the silicon waveguide and reduces the mode overlap with the quantum wells. The confinement factor can be optimized along the length of the SOA by tapering the Si waveguide width.

Another consideration for the SOA location is the nonlinear optical loss from two-photon absorption (TPA) in the Si waveguides of the silicon photonic transceiver. In the telecom wavelengths, this loss increases with total power in the waveguide effectively limiting the power within the silicon waveguides. Because the SOAs 1202, 1204, 1206 at the input of the transceiver may be amplifying continuous-wave light from the tunable laser, signal distortion from the SOA nonlinearities are not a concern.

Region 1200b includes embodiments of SOAs 1222, 1224, 1226 placed in the transmitter 1200b either after IQ modulators 1220 or after the polarization rotator 1228 and polarization combiner 1230. The IQ modulators 1220, which in embodiments may be nested Si MZ modulators, may have a significant amount of loss, for example, on the order of 16dB. This loss, in addition to the inherent penalty from the modulation format, lowers the output power required from the SOAs 1222, 1224, 1226. This may be because the output power from the SOAs 1222, 1224, 1226 is not limited by two photon absorption (TPA), and the SOA 1222, 1224, 1226 gain can be higher compared to placement at the input of the transceiver. In addition, having an SOA 1222, 1224 for each polarization also offers the ability to balance the power between the two polarizations by tuning the gain in each SOA.

In embodiments, a polarization independent SOA 1226 may be used or required if the SOA 1226 is placed after the polarization rotator 1228 and polarization combiner 1230 in the transmitter 1200b. Compared to SOAs 1222, 1224 optimized for amplifying a single polarization where compressively strained multiple quantum well gain material is commonly used, an SOA 1226 with low polarization dependent gain may require different III-V gain material, such as bulk active material or tensile strained quantum wells, where the amount of strain is set to equalize the TE and TM gain. Using a single SOA 1226 to amplify both polarizations offers reduced power consumption compared to using two SOAs 1222, 1224 after each of the IQ modulators 1220. However, if there is only 1 SOA 1226 for both polarizations, there is a lack of ability to equalize power between the two polarizations.

The performance transmitter 1200b with SOAs 1222, 1224, 1226 amplifying data is limited by amplified spontaneous emission (ASE) for low input powers and by nonlinear distortions at high input powers. The optimum range of input powers to the SOAs 1222, 1224, 1226 may be extracted from transmission system simulations with known or estimated link losses and SOA parameters to guide the decision on SOA placement within the transceiver 1200 among all the described options after modulation. One important parameter for SOAs is the noise figure (NF) that describes the amount of degradation from the spontaneous emission in the amplification process, or the ratio in decibel scale of the SNR (signal-to-noise ratio) at the input of the SOA to the SNR at the output of the SOA. A lower NF is desirable and indicates lower signal degradation during the amplification process.

Region 1200c is a receiver that includes embodiments of SOAs 1242, 1244, 1246 placement in the receiver 1200c before or after the polarization splitter 1248 and polarization rotator 1250, 1251. In embodiments, a polarization independent SOA may be required if the SOA 1246 is placed before the polarization splitter 1248 and polarization rotator 1250. This configuration offers reduced power consumption compared to using two SOAs 1242, 1244, one for each polarization. SOAs 1242, 1244 placement in the receiver 1200c after the input dual-polarization signal is split and rotated, and before it is mixed with the receiver local oscillator 1250 in a 90-degree optical hybrid, allows for separate power tuning of the two polarizations.

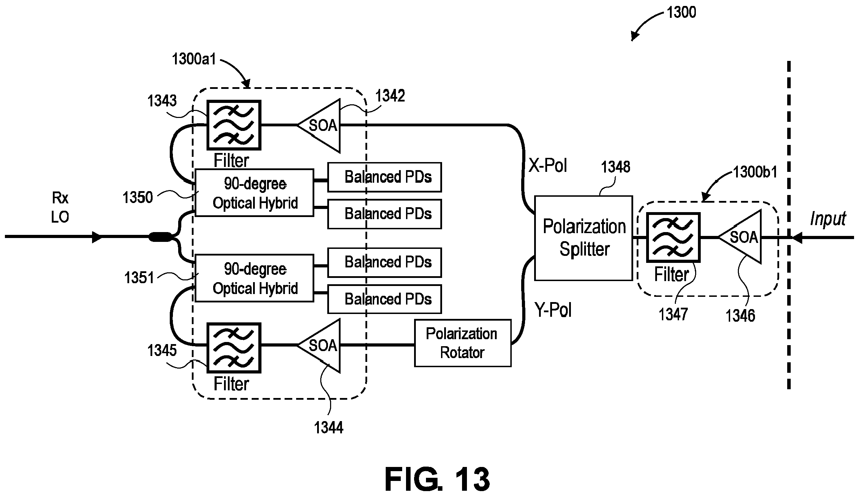

FIG. 13 illustrates filter locations within a dual polarization transceiver with multiple SOAs to eliminate excess ASE, in accordance with various embodiments. Receiver portion 1300 may be similar to receiver 1200c of FIG. 12, with SOA 1342, 1344, 1346 similar, respectively, to SOA 1242, 1244, 1246 of FIG. 12. As shown with respect to region 1300a1, band pass filter 1343 may be placed between SOA 1342 and 90-degree optical hybrid 1350, and band pass filter 1345 may be placed between SOA 1344 and 90-degree optical hybrid 1351. As shown with respect to region 1300b1, a band pass filter 1347 may be placed between the SOA 1346 and polarization splitter 1348, which may be similar to polarization splitter 1248 of FIG. 12.

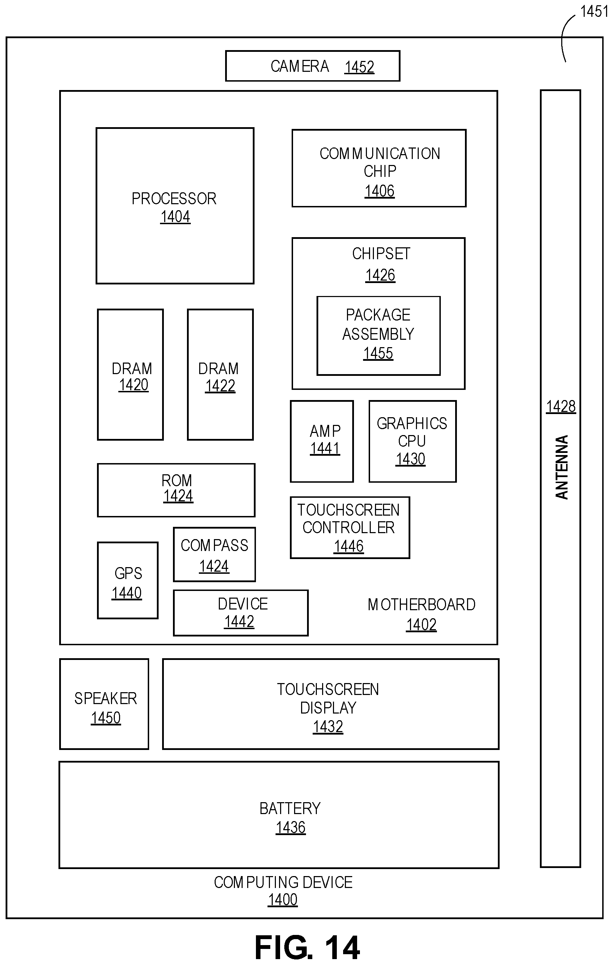

Embodiments of the present disclosure may be implemented into a system using any suitable hardware and/or software to configure as desired. FIG. 14 schematically illustrates a computing device 1400 in accordance with one embodiment. The computing device 1400 may house a board such as motherboard 1402 (i.e., housing 1451). The motherboard 1402 may include a number of components, including but not limited to a processor 1404 and at least one communication chip 1406. The processor 1404 may be physically and electrically coupled to the motherboard 1402. In some implementations, the at least one communication chip 1406 may also be physically and electrically coupled to the motherboard 1402. In some embodiments, communication chip 1406 is incorporated with the teachings of the present disclosure. That is, it includes one or more SOAs integrated within a photonics apparatus. In further implementations, the communication chip 1406 may be part of the processor 1404. In other embodiments, one or more of the other enumerated elements may be incorporated with the teachings of the presented disclosure.

Depending on its applications, computing device 1400 may include other components that may or may not be physically and electrically coupled to the motherboard 1402. These other components may include, but are not limited to, volatile memory (e.g., DRAM) 1420, nonvolatile memory (e.g., ROM) 1424, flash memory 1422, a graphics processor 1430, a digital signal processor (not shown), a crypto processor (not shown), a chipset 1426, an antenna 1428, a display (not shown), a touchscreen display 1432, a touchscreen controller 1446, a battery 1436, an audio codec (not shown), a video codec (not shown), a power amplifier 1441, a global positioning system (GPS) device 1440, a compass 1442, an accelerometer (not shown), a gyroscope (not shown), a speaker 1450, a camera 1452, and a mass storage device (such as hard disk drive, compact disk (CD), digital versatile disk (DVD), and so forth) (not shown). Further components, not shown in FIG. 14, may include a microphone, a filter, an oscillator, a pressure sensor, or an RFID chip. In embodiments, one or more of the package assembly components 1455 may include one or more SOAs integrated within a photonics apparatus, as discussed herein.

The communication chip 1406 may enable wireless communications for the transfer of data to and from the computing device 1400. The term "wireless" and its derivatives may be used to describe circuits, devices, systems, processes, techniques, communications channels, etc., that may communicate data through the use of modulated electromagnetic radiation through a non-solid medium. The term does not imply that the associated devices do not contain any wires, although in some embodiments they might not. The communication chip 1406 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible BWA networks are generally referred to as WiMAX networks, an acronym that stands for Worldwide Interoperability for Microwave Access, which is a certification mark for products that pass conformity and interoperability tests for the IEEE 802.16 standards. The communication chip 1406 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 1406 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 1406 may operate in accordance with Code Division Multiple Access (CDMA), Time Division Multiple Access (TDMA), Digital Enhanced Cordless Telecommunications (DECT), Evolution-Data Optimized (EV-DO), derivatives thereof, as well as any other wireless protocols that are designated as 3G, 4G, 5G, and beyond. The communication chip 1406 may operate in accordance with other wireless protocols in other embodiments. In embodiments, the communication chip 1406 may include one or more SOAs integrated within a photonics apparatus, as discussed herein.

The computing device 1400 may include a plurality of communication chips 1406. For instance, a first communication chip 1406 may be dedicated to shorter range wireless communications such as Wi-Fi and Bluetooth and a second communication chip 1406 may be dedicated to longer range wireless communications such as GPS, EDGE, GPRS, CDMA, WiMAX, LTE, Ev-DO, and others.

The processor 1404 of the computing device 1400 may include a die in a package assembly such as, for example, one or more SOAs within a photonics apparatus, as described herein. The term "processor" may refer to any device or portion of a device that processes electronic data from registers and/or memory to transform that electronic data into other electronic data that may be stored in registers and/or memory.

In various implementations, the computing device 1400 may be a laptop, a netbook, a notebook, an ultrabook, a smartphone, a tablet, a personal digital assistant (PDA), an ultra mobile PC, a mobile phone, a desktop computer, a server, a printer, a scanner, a monitor, a set-top box, an entertainment control unit, a digital camera, a portable music player, or a digital video recorder. In further implementations, the computing device 1400 may be any other electronic device that processes data, for example, an all-in-one device such as an all-in-one fax or printing device.

Various embodiments may include any suitable combination of the above-described embodiments including alternative (or) embodiments of embodiments that are described in conjunctive form (and) above (e.g., the "and" may be "and/or"). Furthermore, some embodiments may include one or more articles of manufacture (e.g., non-transitory computer-readable media) having instructions, stored thereon, that when executed result in actions of any of the above-described embodiments. Moreover, some embodiments may include apparatuses or systems having any suitable means for carrying out the various operations of the above-described embodiments.

The above description of illustrated implementations, including what is described in the Abstract, is not intended to be exhaustive or to limit the embodiments of the present disclosure to the precise forms disclosed. While specific implementations and examples are described herein for illustrative purposes, various equivalent modifications are possible within the scope of the present disclosure, as those skilled in the relevant art will recognize.

These modifications may be made to embodiments of the present disclosure in light of the above detailed description. The terms used in the following claims should not be construed to limit various embodiments of the present disclosure to the specific implementations disclosed in the specification and the claims. Rather, the scope is to be determined entirely by the following claims, which are to be construed in accordance with established doctrines of claim interpretation.

Some non-limiting examples are provided below.

### Examples

Example 1 is a silicon photonics integrated apparatus, comprising: an input to receive an optical signal; a splitter optically coupled to the input to split the optical signal into a first path and a second path; a polarization beam splitter and rotator (PBSR) optically coupled with the first path or the second path; a semiconductor optical amplifier (SOA) optically coupled with the first path or the second path and disposed between the splitter and the PBSR.
Example 2 may include the apparatus of example 1, further comprising: a modulator optically coupled to the first path and the second path, wherein the modulator is disposed between the splitter and the PBSR.
Example 3 may include the apparatus of example 2, wherein the SOA is disposed between the splitter and the modulator to amplify light received from the first path and/or the second path.
Example 4 may include the apparatus of example 2, wherein the SOA is disposed between the modulator and the PRBC.
Example 5 may include the apparatus of example 2, wherein the SOA is a first SOA that is disposed between the splitter and the modulator; and further comprising a second SOA that is disposed between the modulator and the PRBC.
Example 6 may include the apparatus of example 2, wherein the SOA includes Indium Phosphide (InP).
Example 7 may include the apparatus of any one of examples 1-6, wherein the SOA is a hybrid SOA.
Example 8 may include the apparatus of any one of examples 1-6, wherein the SOA is defined by silicon waveguides on a wafer of the apparatus.
Example 9 may include the apparatus of any one of examples 1-6, wherein the first path carries an X polarization of light and the second path carries a Y polarization of light.
Example 10 may include the apparatus of example 2, wherein the modulator includes multiple branches; and further comprising: the SOA is disposed in one of the multiple branches.
Example 11 may include the apparatus of any one of examples 1-6, wherein the apparatus is a modulator or receiver.
Example 12 is a coherent receiver apparatus, comprising: an input to receive an optical signal; a PBSR optically coupled to the input to split the optical signal into an X path and a Y path; an SOA coupled with the X path or the Y path to amplify the signal; and a photodetector coupled with an output of the SOA.
Example 13 may include the apparatus of example 12, wherein the photodetector further includes a plurality of photodetectors.
Example 14 may include the apparatus of example 12, wherein the SOA is coupled with the X path and the Y path to amplify the signal.
Example 15 may include the apparatus of any one of examples 12-14, wherein the SOA includes InP.
Example 16 may include the apparatus of any one of examples 12-14, wherein the SOA is a single piece of epitaxial medium bonded onto a silicon wafer.
Example 17 is a laser apparatus, comprising: a laser component having a first end and a second end opposite the first end, the laser component to emit light from the second end of the laser component; a back absorber optically coupled with the first end of the laser component; a first end of an SOA optically coupled with the second end of the laser component to amplify the emitted light from the second end of the laser component; and an output coupled with a second end of the SOA opposite the first end of the SOA.
Example 18 may include the apparatus of example 17, wherein the laser component is a III-V/Si hybrid laser.
Example 19 may include the apparatus of any one of example 17-18, wherein the SOA is a III-V/Si hybrid SOA.
Example 20 is a modulator apparatus comprising: a micro ring modulator (MRM) with an input to receive light and an output to emit light; an input of an SOA coupled with the output of the MRM to amplify the emitted light from the output of the MRM; and wherein an output of the SOA emits the amplified light.
Example 21 may include the apparatus of example 20, wherein the MRM and the SOA are coupled to a single silicon wafer.
Example 22 may include the apparatus of example 20, wherein the SOA is a III/V/Si hybrid SOA.
Example 23 may include the apparatus of any one of examples 20-22, wherein the SOA is to control heating of the MRM during operation.
Example 24 is a receiver apparatus comprising: an input to receive an optical signal; an SOA with a first end optically coupled with the input to amplify the received optical signal; and a silicon photodetector optically coupled with a second end of the SOA.
Example 25 may include the apparatus of example 24, wherein the SOA is a III/V Si SOA.
Example 26 may include the apparatus of example 24, wherein the SOA is a hybrid SOA.
Example 27 may include the apparatus of any one of examples 24-26, wherein the SOA and the silicon photodetector are on a same wafer.
Example 28 is a receiver apparatus comprising: an SOA with an input to receive an optical signal and to output an amplified signal; and a germanium (Ge) photodetector (PD), optically coupled with an output of the SOA, to convert the amplified optical signal to an electrical signal.
Example 29 may include the apparatus of example 28, wherein the SOA is a dual polarization SOA or a polarization insensitive SOA.
Example 30 may include the apparatus of example 29, wherein the received optical signal includes a combination of transverse electric (TE) signals and transverse magnetic (TM) signals.
Example 31 may include the apparatus of example 29, wherein the amplified optical signal includes amplified TE signals and TM signals.
Example 32 may include the apparatus of example 28, wherein the SOA and the germanium photodetector are on a same wafer.
Example 33 may include the apparatus of example 28, wherein the SOA is a first SOA, wherein the Ge PD is a first Ge PD; and further comprising: a polarization splitter-rotator (PSR); and a second SOA and a second Ge PD, wherein an input of the first SOA and an input of the second SOA are to receive a signal from the PSR, wherein an output of the second SOA is optically coupled to an input of the second Ge PD.
Example 34 may include the apparatus of example 33, wherein the PSR receives a TE signal and a TM signal; and wherein the PSR outputs the TE signal to the first SOA and a TE' signal to the second SOA, wherein the TE' signal is a rotated polarization of the TM signal received by the PSR.
Example 35 may include the apparatus of any one of examples 33-34, wherein the first or second SOA is a dual polarization SOA or a polarization insensitive SOA.
Example 36 may include the apparatus of example 28, further comprising a PSR/Combiner optically coupled with the input of the SOA, wherein the PSR/Combiner receives as input a combination TE and TM optical signal and outputs a combination TE and TE' signal, wherein the TE' signal is a rotated polarization of the TM signal.
Example 37 may include the apparatus of example 36, wherein the SOA is polarization sensitive.
Example 38 may include the apparatus of any one of examples 36-37, wherein the output of the PSR/Combiner travels on one waveguide.
Example 39 may include the apparatus of example 36, wherein the input to the PSR/Combiner includes a plurality of wavelengths, and wherein the Ge PD is a plurality of Ge PDs; and further comprising a demux disposed between and optically connected with the SOA and with the plurality of Ge PDs, wherein the demux routes, respectively, one of the plurality of wavelengths to one of the plurality of Ge PDs.
Example 40 may include the apparatus of any one of examples 26-39, wherein the apparatus is a selected one of: a modulator, a receiver, a transmitter, or a transceiver.

## Claims

1. A silicon photonics integrated apparatus, comprising:
an input to receive an optical signal;
a splitter optically coupled to the input to split the optical signal into a first path and a second path;
a polarization beam splitter and rotator (PBSR) optically coupled with the first path or the second path;
a semiconductor optical amplifier (SOA) optically coupled with the first path or the second path and disposed between the splitter and the PBSR.

2. The apparatus of claim 1, further comprising:
a modulator optically coupled to the first path and the second path, wherein the modulator is disposed between the splitter and the PBSR.

3. The apparatus of claim 2, wherein the SOA is disposed between the splitter and the modulator to amplify light received from the first path and/or the second path.

4. The apparatus of claim 2, wherein the SOA is disposed between the modulator and the PRBC.

5. The apparatus of claim 2, wherein the SOA is a first SOA that is disposed between the splitter and the modulator; and
further comprising a second SOA that is disposed between the modulator and the PRBC.

6. The apparatus of claim 2, wherein the SOA includes Indium Phosphide (InP).

7. The apparatus of claim 2, wherein the SOA is a hybrid SOA.

8. The apparatus of claim 2, wherein the SOA is defined by silicon waveguides on a wafer of the apparatus.

9. The apparatus of claim 2, wherein the first path carries an X polarization of light and the second path carries a Y polarization of light.

10. The apparatus of any one of claims 2-9, wherein the modulator includes multiple branches; and further comprising: the SOA is disposed in one of the multiple branches.

11. A coherent receiver apparatus, comprising:
an input to receive an optical signal;
a PBSR optically coupled to the input to split the optical signal into an X path and a Y path;
an SOA coupled with the X path or the Y path to amplify the signal; and
a photodetector coupled with an output of the SOA.

12. The apparatus of claim 11, wherein the photodetector further includes a plurality of photodetectors.

13. The apparatus of claim 11, wherein the SOA is coupled with the X path and the Y path to amplify the signal.

14. The apparatus of claim 11, wherein the SOA includes InP.

15. The apparatus of any one of claims 11-14, wherein the SOA is a single piece of epitaxial medium bonded onto a silicon wafer.
